Europäisches Patentamt

European Patent Office

Office européen des brevets

(11) Numéro de publication: **0 176 459**
**B1**

## FASCICULE DE BREVET EUROPÉEN

(45) Date de publication du fascicule du brevet:
04.01.89

(51) Int. Cl.⁴: **H 04 M 1/60,** H 04 R 25/00,
H 03 H 19/00

(21) Numéro de dépôt: 85430028.2

(22) Date de dépôt: 05.09.85

(54) Ecouteur, combiné téléphonique et casque d'écoute destinés à corriger les déficiences auditives individuelles.

(30) Priorité: 07.09.84 FR 8413891

(43) Date de publication de la demande:
02.04.86 Bulletin 86/14

(45) Mention de la délivrance du brevet:
04.01.89 Bulletin 89/1

(84) Etats contractants désignés:
AT BE CH DE FR GB IT LI LU NL SE

(56) Documents cité:
BE-A-690 001
CH-A-536 577
DE-A-1 512 717
FR-A-2 511 211
GB-A-2 116 388

1981 IEEE INTERNATIONAL SYMPOSIUM ON
CIRCUITS AND SYSTEMS PROCEEDINGS, vol. 1/3,
27-29 avril 1981, pages 303-306, Chicago, US, IEEE,
New York, US; W. BRANDENBUSCH: "Multiple
parameter tunable active integrator filters"

(73) Titulaire: CENTRE NATIONAL DE LA RECHERCHE
SCIENTIFIQUE (CNRS), 15, Quai Anatole France,
F-75700 Paris Cedex 07 (FR)

(72) Inventeur: Angelini, Théophile, 31, rue Raphael,
F-13008 - Marseille (FR)
Inventeur: Canevet, Georges, Bâtiment B5
Valmante Michelet, F-13009 - Marseille (FR)
Inventeur: Foti, Marc, Allée des Pins Les
Romarins, F-13009 - Marseille (FR)
Inventeur: Santon, François, Château Sec A2,
F-13009 - Mariseille (FR)

(74) Mandataire: Azais, Henri, c/o CABINET BEAU DE
LOMENIE 14, rue Raphael, F-13008 Marseille (FR)

## Description

La présente invention a pour objet des écouteurs, notamment des écouteurs de casques d'écoute ou de combinés téléphoniques destinés à corriger les déficiences auditives individuelles.

Le secteur technique de l'invention est celui de la construction des matériels découte téléphonique ou radiophonique.

Un pourcentage important de la population souffre de déficiences auditives qui se manifestent généralement par une mauvaise perception des sons situés dans une bande de fréquences dont la position et la largeur varient selon les individus.

Les malentendants ont souvent des difficultés pour téléphoner ou pour se servir de casques d'écoute radio ou téléphonique du fait que la voix est déformée et qu'ils comprennent mal leur interlocuteur.

Un des objectifs de la présente invention est de procurer des écouteurs incorporés à des combinés téléphoniques ou à des casques d'écoute, autonomes et personnalisés, de telle sorte qu'un malentendant peut posséder son propre combiné de téléphone ou son casque d'écoute qu'il a réglé pour corriger ses déficiences auditives et il peut se déplacer avec ce combiné ou ce casque pour les utiliser avec n'importe quel appareil téléphonique ou radiophonique.

Un autre objectif de la présente invention est de procurer des combinés téléphoniques autonomes, ayant une alimentation électrique incorporée, et personnalisés du fait qu'ils comportent des circuits électroniques réglables qui permettent de corriger les déficiences auditives propres à l'utilisateur et ces combinés ou casques d'écoute personnalisés peuvent être connectés sur un appareil téléphonique ou sur un récepteur de radio par une liaison par capteur électromagnétique à induction ou par une liaison hertzienne, de sorte qu'ils peuvent être utilisés avec n'importe quel appareil téléphonique sans aucun branchement de fil sur celui-ci et sans avoir à obtenir un agrément de l'exploitant des réseaux téléphoniques.

Un autre objectif de la présente invention est de procurer des écouteurs incorporés à des combinés téléphoniques ou à des casques d'écoute qui peuvent être fabriques en série et ajustés individuellement aux déficiences auditives particulières de leur utilisateur habituel ou même aux déficiences de plusieurs utilisateurs successifs.

On connaît des combinés téléphoniques pour déficients auditifs qui comportent un amplificateur à gain variable qui permet d'amplifier le son uniformément dans toutes les fréquences.

On connaît également des écouteurs téléphoniques spéciaux pour malentendants munis d'une prothèse auditive. Ces écouteurs sont couplés à une bobine magnétique qui permet de transmettre par induction des signaux électromagnétiques à la prothèse auditive placée sur la position téléphone (T).

Le premier de ces dispositifs connus permet d'améliorer la perception des sons en augmentant le niveau sonore général mais il n'apporte aucune correction adaptée à la déficience individuelle de l'utilisateur.

Le deuxième de ces dispositifs connus permet de téléphoner en utilisant une prothèse auditive mais il n'apporte aucune correction autre que celle qui est due à la prothèse.

La demande de brevet FR-A-2 511 211 (Société LEM) décrit des combinés téléphoniques pour les déficients auditifs qui comportent un réseau de filtrage ajustable à l'aide d'un tournevis qui permet d'adapter la courbe de réponse de l'écouteur du combiné téléphonique à la courbe de l'audiogramme d'un utilisateur du combiné.

Ce document décrit le résultat recherché: adapter la courbe de réponse de l'écouteur à l'audiogramme de l'utilisateur, mais il ne contient aucun enseignement relatif aux moyens techniques utilisés pour atteindre ce résultat.

Ce document n'enseigne pas de faire varier indépendamment l'une de l'autre la largeur et la fréquence centrale de la bande passante d'un filtre pour la faire coïncider avec la plage de déficience acoustique de l'utilisateur.

Le brevet DE-A-1 512 717 décrit des dispositifs protecteurs contre les bruits.

Ces dispositifs comportent des écouteurs plaqués contre les oreilles et des microphones qui sont connectés aux écouteurs par des circuits électroniques comportant un amplificateur à contrôle automatique de gain et un filtre à bande passante qui laisse passer une bande de fréquences sonores nécessaires à la bonne compréhension des paroles et un filtre réjecteur qui élimine une fréquence particulière.

Ce brevet décrit un écouteur combiné à des filtres qui n'ont pas pour effet technique d'améliorer l'audition par des malentendants.

Un dispositif selon l'invention renforce la perception des fréquences situées dans une bande de fréquences dont l'utilisateur peut ajuster la largeur et la position pour la faire coïncider avec la bande de fréquences que son oreille a des difficultés à percevoir de sorte que finalement un écouteur équipé d'un dispositif selon l'invention a pour effet technique que l'oreille collée à cet écouteur perçoit bien toutes les fréquences.

Les objectifs de l'invention sont atteints au moyen d'écouteurs, notamment des écouteurs de combiné téléphonique ou de casques d'écoute qui comportent un filtre électronique passe-bande et des moyens électroniques commandés par des moyens actionnables par l'utilisateur pour faire varier indépendamment l'une de l'autre la fréquence centrale et la largeur de la bande passante dudit filtre pour la faire correspondre à la plage de déficience acoustique.

Selon un mode de réalisation préférentiel, les moyens pour faire varier indépendamment l'une de l'autre la fréquence centrale et la largeur de bande dudit filtre comportent des interrupteurs électroniques qui sont associés à des résistances incorporées audit filtre et ils comportent, en outre, des moyens pour envoyer sur la gâchette desdits interrupteurs électroniques des trains d'impulsions rectangulaires et des moyens pour faire varier le rapport cyclique desdits trains d'impulsions, ce qui permet de faire varier lesdites résistances et d'ajuster indépendamment l'une de l'autre, la fréquence centrale et la largeur de la bande passante dudit filtre.

Le résultat de l'invention est constitué par de nouveaux écouteurs, qui comportent des circuits incorporés permettant à un malentendant de corriger lui-même, par des moyens électroniques, le spectre d'émission de l'écouteur, de sorte que celui-ci présente un renforcement des signaux électriques et acoustiques dans une bande passante qui recouvre sensiblement la bande passante dans laquelle se situe la déficience auditive de l'utilisateur.

Les écouteurs selon l'invention présentent l'avantage de pouvoir être fabriqués en série sur le même modèle pour être réglés ensuite individuellement par chaque utilisateur selon ses besoins personnels.

Les écouteurs selon l'invention permettent de fabriquer des combinés téléphoniques ou des casques d'écoute autonomes et personnalisés qui peuvent être transportés par l'utilisateur et connectés sans aucun branchement de fil, sur n'importe quel poste téléphonique, de sorte qu'un malentendant, dont les déficiences sont telles qu'il peut difficilement comprendre ses interlocuteurs au téléphone, peut ainsi corriger ses déficiences et téléphoner de n'importe quel poste téléphonique.

Les écouteurs selon l'invention, qui comportent des moyens de correction incorporés à chaque écouteur et adaptables à la déficience de l'oreille sur laquelle est placée l'écouteur, permettent notamment de réaliser des casques d'écoute à deux écouteurs personnalisés et autonomes sur lesquels l'utilisateur peut régler indépendamment la correction de chaque écouteur en fonction de la déficience de chaque oreille: De tels casques d'écoute personnalisés peuvent être utilisés avantageusement par les opérateurs dont la profession exige le port d'un casque d'écoute, par exemple les standardistes, les contrôleurs de navigation, les reporters de radio etc...

Par rapport à des moyens de correction qui seraient incorporés dans un appareil téléphonique, les moyens selon l'invention qui sont incorporés directement à l'écouteur permettent de réaliser des combinés téléphoniques ou des casques d'écoute personnalisés et transportables d'un appareil à un autre.

La description suivante se réfère aux dessins annexés qui représentent, sans aucun caractère limitatif, un exemple de réalisation d'un écouteur selon l'invention.

La figure 1 est un schéma synoptique des composants essentiels d'un dispositif selon l'invention.

La figure 2 est un schéma d'un mode de réalisation préférentiel d'un dispositif selon la figure 1.

La figure 3 est une vue en perspective d'un combiné téléphonique selon l'invention.

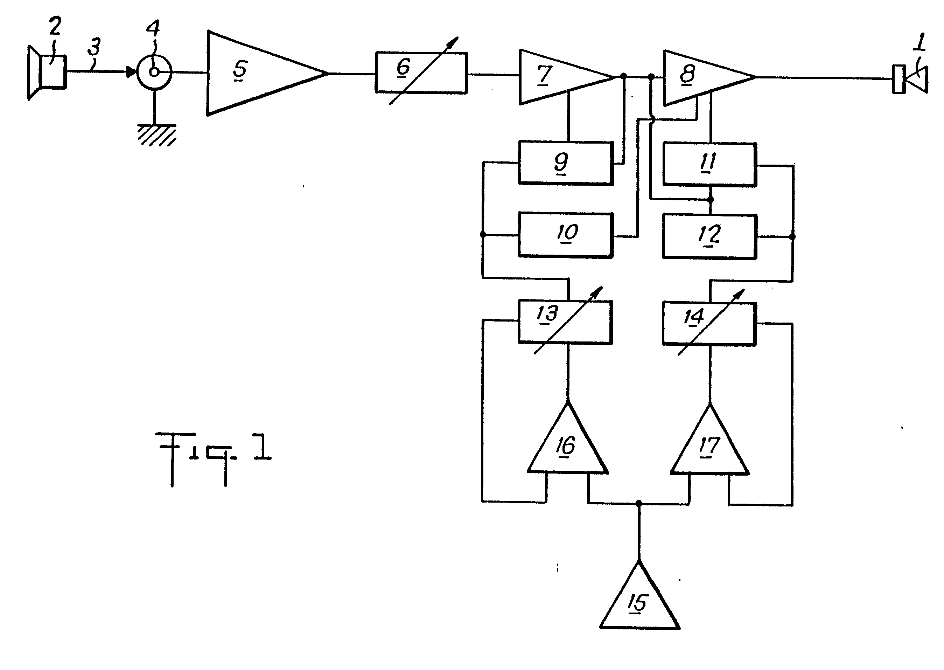

La figure 1 représente un écouteur 1 qui est un transducteur électro-acoustique de tout type connu et qui est par exemple un écouteur de casque d'écoute téléphonique ou radiophonique.

La figure 1 représente un écouteur téléphonique 1 qui est relié à un poste téléphonique par un capteur électromagnétique à induction 2 qui est muni d'une ventouse qui est appliquée contre l'appareil téléphonique et qui est connecté par un câble 3 sur une douille d'entrée 4. Cette liaison par capteur et câble pourrait être remplacée par une liaison hertzienne, comme il en existe sur certains combinés téléphoniques portatifs.

Les circuits électroniques sont incorporés dans le support de l'écouteur, par exemple dans un combiné téléphonique ou dans un casque d'écoute. Ils comportent un préamplificateur 5 à gain variable. Le repère 6 représente un potentiomètre qui permet de régler le gain du préamplificateur.

Les signaux électriques sortant du préamplificateur passent dans un filtre passe bande qui comporte deux amplificateurs opérationnels 7 et 8 associés à des interrupteurs électroniques 9, 10, 11 et 12. Ces interrupteurs électroniques sont par exemple des interrupteurs faisant partie d'un circuit intégré CD 4016 vendu par NATIONAL SEMI CONDUCTORS, qui comporte quatre interrupteurs sur une même plaquette. Chaque interrupteur a trois bornes, une borne d'entrée, une borne de sortie et une borne de gâchette.

La résistance entre la borne d'entrée et de sortie varie de façon continue entre 0 et 10 KΩ, selon le rapport cyclique d'un train d'impulsions rectangulaires à fréquence constante appliqué sur la gâchette.

Les interrupteurs électroniques 9 et 10 permettent de faire varier la fréquence centrale de la bande passante du filtre en agissant sur un potentiomètre 13.

Les interrupteurs électroniques 11 et 12 permettent de faire varier la largeur de la bande passante du filtre en agissant sur un potentiomètre 14.

Les interrupteurs électroniques 9 et 10, d'une part et 11 et 12, d'autre part, sont commandés en parallèle par des trains d'impulsions rectangulaires à rapport cyclique variable.

Le repère 15 représente un multivibrateur astable qui émet une tension à fréquence constante triangulaire, c'est-à-dire une tension qui croît progressivement avec une pente constante et qui décroît brusquement. Cette tension est envoyée en parallèle sur les bornes d'entrées de même polarité de deux amplificateurs opérationnels 16 et 17 montés en comparateur, qui comparent chacun cette tension à une tension de référence, dont le niveau est réglé par les potentiomètres 13 et 14.

Tant que la tension croissante est inférieure à la tension de référence qui lui est appliquée, le comparateur 16 ou 17 émet un signal d'un niveau déterminé par exemple de niveau zéro.

Aussitôt que la tension croissante devient supérieure à la tension de référence qui lui est appliquée, le comparateur 16 ou 17 émet un signal de niveau inverse du précédent. On voit donc que les comparateurs 16 et 17 émettent chacun un train d'impulsions rectangulaires, dont la fréquence est constante et égale à la fréquence du multivibrateur 15 et dont le rapport cyclique, c'est-à-dire le rapport entre la durée des impulsions et la durée des intervalles séparant deux impulsions varie en fonction des tensions de référence appliquées par les potentiomètres 13 et 14 aux entrées des comparateurs 16 et 17.

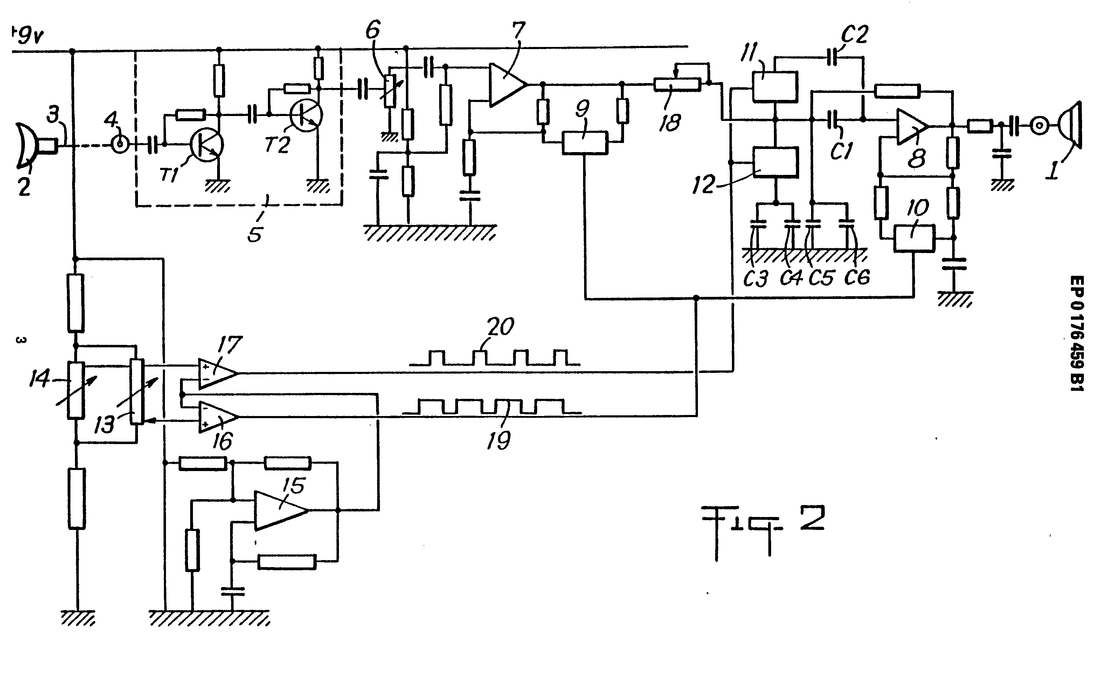

La figure 2 représente un mode de réalisation préférentiel d'un dispositif selon la figure 1. On retrouve sur la figure 2 un capteur 2 qui est par exemple un capteur à induction, qui est connecté par un câble 3 sur une borne d'entrée 4 du dispositif.

La figure 2 représente, dans un rectangle 5 en traits interrompus, un mode de réalisation d'un préamplificateur composée deux transistors T1 et T2.

Le repère 6 représente un potentiomètre qui permet de faire varier le gain du préamplificateur 5.

Le repère 7 représente un amplificateur opérationnel qui comporte une boucle de contre réaction, dans laquelle est monté un interrupteur électronique 9, qui permet de faire varier de façon continue, la résistance de la boucle de contre réaction.

L'amplificateur 7 et la boucle de contre réaction constistuent un amplificateur sélectif et, en faisant varier la contre réaction, on fait varier la bande passante.

Le repère 18 représente un potentiomètre qui est réglé à la construction et qui permet d'ajuster les limites entre lesquelles il est possible de faire varier la fréquence centrale de la bande passante.

La sortie du potentiomètre 18 est connectée sur un ensemble de condensateurs de filtrage C1, C2, C3 et C4, montés en parallèle, C5 et C6, montés également en parallèle.

Le condensateur C2 est monté en série avec un interrupteur électronique 11 à résistance variable. De même, les condensateurs C3 et C4 sont montés en série avec un interrupteur électronique 12 à résistance variable.

Les condensateurs et les résistances constituent un filtre passe bande et en faisant varier de façon continue les résistances 11 et 12, on fait varier la largeur de la bande passante de ce filtre.

Le repère 8 représente un deuxième amplificateur sélectif qui comporte, dans sa boucle de contre réaction, un interrupteur électronique à résistance variable 10.

Les amplificateurs sélectifs 7 et 8 constituent un filtre passe bande et en faisant varier les résistances des interrupteurs 9 et 10, on fait varier la fréquence centrale de la bande passante de ce filtre.

Le repère 15 représente un multivibrateur astable qui émet une tension en triangle à fréquence constante ce multivibrateur est constitué par exemple par un circuit intégré vendu par FAIRCHILD sous la référence MA 741.

La sortie du multivibrateur 15 est connectée en parallèle sur les bornes de polarité négative de deux amplificateurs opérationnels 16 et 17.

Les bornes de polarité positive de ces deux amplificateurs sont connectées respectivement sur deux potentiomètres 13 et 14 qui permettent de faire varier indépendamment les tensions de référence appliquées à ces bornes positives. Chaque amplificateur 16 et 17 compare la tension progressivement croissante délivrée par le multivibrateur 15 à une tension de référence et émet une impulsion en forme de créneau rectangulaire pendant tout le temps où la tension variable est supérieure à la tension de référence. La largeur de ces impulsions et donc le rapport cyclique des trains d'impulsions émis par les comparateurs 16 et 17 sont donc fonction de la tension de référence et donc de la position des potentiomètres 13 et 14.

On a représenté sur la figure 2 deux trains d'impulsions 19 et 20 ayant même fréquence et des rapports cycliques différents.

Le train d'impulsion 19 émis par le comparateur 16 est envoyé en parallèle sur les gâchettes des interrupteurs électroniques 9 et 10, dont la résistance varie en fonction du rapport cyclique du train d'impulsions 19. Le potentiomètre 13 permet donc de faire varier la fréquence centrale de la bande passante du filtre constitué par les amplificateurs sélectifs 7 et 8.

De même, le train d'impulsions 20 émis par le comparateur 17 est envoyé en parallèle sur les gâchettes des deux interrupteurs électroniques 11 et 12 dont la résistance varie en fonction du rapport cyclique du train d'impulsions 20.

Le potentiomètre 14 permet donc de faire varier la largeur de la bande passante du filtre.

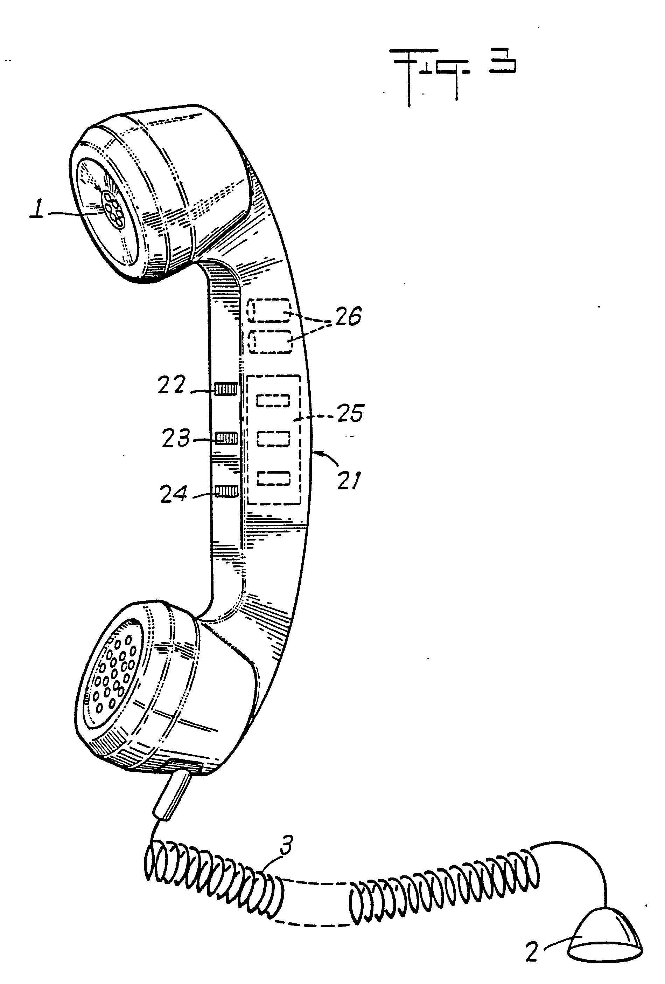

La figure 3 est une vue en perspective d'un combiné téléphonique selon l'invention 21.

Ce combiné 21 comporte dans le manche reliant le microphone à l'écouteur un ensemble 25 de circuits selon la figure 2 qui peuvent être réalisés en circuits intégrés peu encombrants. Il comporte une source de courant continu 26 par exemple des piles ou une petite batterie rechargeable qui alimente ces circuits.

Il comporte trois molettes 22, 23 et 24. La molette 22 agit sur le potentiomètre 6. Elle permet de régler le gain de préamplification 5 et donc le niveau sonore global.

Les molettes 23 et 24 commandent les potentiomètres 13 et 14 et permettent de régler respectivement la fréquence centrale de la bande passante et la largeur de cette bande. Par exemple, la fréquence centrale est ajustable entre 800 Hz et 4,5 Hz et on peut faire varier la largeur de la bande passante entre 100 Hz et 3 KHz.

Grâce à la possibilité de régler séparément la position de la bande passante et la largeur de celle-ci, un appareil selon l'invention permet à chacun d'adapter individuellement la correction à ses déficiences auditives et de corriger, de façon satisfaisante, toutes les déficiences partielles que l'on rencontre habituellement chez les malentendants.

Le combiné 21 comporte un cordon 3 portant, à son extrémité, un capteur à ventouse 2, qui peut être appliqué contre un appareil téléphonique sans aucun branchement.

En variante, la liaison entre le combiné 21 et un appareil téléphonique peut être une liaison herzienne.

Un combiné 21 selon l'invention est un combiné autonome grâce à son alimentation incorporée et son capteur 2. Un malentendant peut posséder un tel combiné, le régler pour corriger ses déficiences auditives et le transporter dans ses déplacements pour téléphoner de n'importe quel poste téléphonique.

La figure 3 représente un mode de réalisation dans lequel tous les combinés sont fabriqués en série selon le même modèle et chacun peut adapter son combiné à ses déficiences personnelles.

En variante, on peut réaliser des combinés selon l'invention comportant des filtres réalisés sous forme de modules enfichables et, dans ce cas, un médecin peut mesurer l'audiogramme d'un patient, en déduire la position et la largeur de la bande de fréquence où l'audition est déficiente et placer dans le combiné un filtre enfichable qui corrige la déficience particulière du patient.

La figure 3 représente un combiné téléphonique autonome et personnalisé. Il est précisé que l'on peut également construire des casques d'écoute autonomes et personnalisés comportant un filtre incorporé au casque et des moyens également incorporés permettant à l'utilisateur de régler la fréquence centrale et/ou la bande passante du filtre.

Dans le cas d'un casque qui comporte deux écouteurs, comme il est fréquent que les malentendants n'aient pas la même déficience aux deux oreilles, on incorpore, au casque, de préférence, deux filtres, un pour chaque écouteur, de sorte que l'utilisateur peut régler indépendamment la correction pour chaque oreille.

Il est précisé que la figure 2 représente seulement un exemple de réalisation des circuits électroniques.

Le filtre passe bande et les moyens pour faire varier la fréquence centrale et la largeur de la bande passante du filtre qui ont été représentés sur cette figure peuvent être remplacés par tout autre moyen électronique équivalent remplissant les mêmes fonctions de filtrage passe bande et de réglage de la fréquence centrale et de la largeur de la bande passante du filtre.

## Revendications

1. Ecouteur (1) de combiné téléphonique ou de casque d'écoute du type comportant un filtre électronique ajustable permettant d'adapter la courbe de réponse de l'écouteur aux déficiences auditives de l'utilisateur, caractérisé en ce que ledit filtre est un filtre passe-bande (7, 8) et ledit écouteur comporte, en outre, des moyens électroniques commandés par des moyens (23, 24) actionnables par l'utilisateur, peur faire varier indépendamment l'une de l'autre la fréquence centrale et la largeur de la bande passante dudit filtre pour la faire correspondre à la plage de déficience acoustique de l'utilisateur.

2. Ecouteur selon la revendication 1, caractérisé en ce que lesdits moyens électroniques pour faire varier indépendamment l'une de l'autre la fréquence centrale et la largeur de bande dudit filtre comportent des interrupteurs électroniques (9, 10, 11, 12) qui sont associés à des résistances incorporées audit filtre et ils comportent, en outre, des moyens pour envoyer sur la gâchette desdits interrupteurs électroniques des trains d'impulsions rectangulaires (19, 20) et des moyens pour faire varier le rapport cyclique desdits trains d'impulsions, ce qui permet de faire varier lesdites résistances et d'ajuster indépendamment l'une de l'autre, la fréquence centrale et la largeur de la bande passante dudit filtre.

3. Ecouteur selon la revendication 2, caractérisé en ce que lesdits moyens pour envoyer sur la gâchette desdits interrupteurs des trains d'impulsions rectangulaires (19, 20) ayant un rapport cyclique variable comportent un générateur (15) de tension triangulaire à fréquence constante, deux comparateurs (16, 17) qui comparent la tension croissante fournie par ledit générateur (15) à une tension de référence et deux potentiomètres (13, 14), actionnables par l'utilisateur, qui permettent de faire varier ladite tension de référence, ce qui a pour effet de faire varier le rapport cyclique des trains d'impulsions rectangulaires délivrés par les deux comparateurs et de faire varier indépendamment l'une de l'autre la fréquence centrale et la largeur de la bande passante dudit filtre.

4. Ecouteur selon la revendication 2, caractérisé en ce que ledit filtre comporte deux amplificateurs sélectifs (7, 8) et deux interrupteurs électroniques (9, 10) qui sont montés dans les boucles de contre-réaction desdits amplificateurs et qui permettent de faire varier la fréquence centrale dudit filtre.

5. Ecouteur selon la revendication 4, caractérisé en ce que ledit filtre comporte, en outre, un filtre composé de condensateurs (C1, C2, C3, C4, C5, C6) et de résisatnce et deux interrupteurs électroniques (11, 12) qui font partie dudit filtre et qui permettent de faire varier la largeur de la bande passante dudit filtre.

6. Combiné téléphonique ou casque d'écoute autonome et personnalisé, caractérisé en ce qu'il comporte un écouteur (1) selon l'une quelconque des revendications 1 à 5, une source de tension incorporée, des moyens de liaison avec un appareil téléphonique par capteur à ventouse (2) ou par liaison herzienne et des molettes (23, 24) actionnables par l'utilisateur, qui permettent de faire varier indépendamment l'une de l'autre, la fréquence centrale et la largeur de bande du ou desdits filtres.

## Patentansprüche

1. Hörteil (1) für einen Telefonhörer oder Kopfhörer, des Typs umfassend einen einstellbaren Elektronikfilter zur Anpassung der Frequenzcharakteristik des Hörteils an die Hörschwäche des Benützers, dadurch gekennzeichnet, daß der Filter ein Bandfilter (7, 8) ist und der Hörteil weiters elektronische Mittel umfaßt, die von durch den Benützer betätigbaren Mitteln (23, 24) gesteuert sind, um unabhängig voneinander die Bandmittenfrequenz und die Breite des Durchlaßbandes des Filters zwecks Angleichung an den Hörschwächebereich des Benützers variieren zu lassen.

2. Hörteil nach Anspruch 1, dadurch gekennzeichnet, daß die elektronischen Mittel zum Variieren der Bandmittenfrequenz und der Breite des Bandes des Filters unabhängig voneinander elektronische Unterbrecher (9, 10, 11, 12) umfassen, die mit im Filter eingebauten Widerständen verbunden sind, und daß sie weiters Mittel (19, 20) zum Senden von Rechteckimpulszügen auf das Substrat der elektronischen Unterbrecher und Mittel zum Variieren des zyklischen Verhältnisses dieser Impulszüge umfassen, was die Veränderung der Widerstände und die Einstellung der mittleren Bandfrequenz und der Breite des Durchlaßbandes des Filters unabhängig voneinander gestattet.

3. Hörteil nach Anspruch 2, dadurch gekennzeichnet, daß die Mittel (19, 20) zum Senden der Rechteckimpulszüge auf das Substrat der Unterbrecher, die ein variables zyklisches Verhältnis haben, einen Dreieckspannungsgenerator (15) mit konstanter Frequenz, zwei Komparatoren (16, 17) zum Vergleichen der vom Generator (15) gelieferten wachsenden Spannung mit einer Referenzspannung und zwei vom Benützer betätigbare Potentiometer (13, 14) umfassen, die eine Veränderung der Referenzspannung gestatten, was die Veränderung des zyklischen Verhältnisses der von den beiden Komparatoren entsendeten Rechteckimpulszüge und die Veränderung der Bandmittenfrequenz und der Breite des Durchlaßbandes des Filters unabhängig voneinander bewirkt.

4. Hörteil nach Anspruch 2, dadurch gekennzeichnet, daß der Filter zwei selektive Verstärker (7, 8) und zwei elektronische Unterbrecher (9, 10) umfaßt, die in Gegenkopplungsschleifen der Verstärker angeordnet sind und die eine Veränderung der Bandmittenfrequenz des Filters gestatten.

5. Hörteil nach Anspruch 4, dadurch gekennzeichnet, daß der Filter weiters einen durch Kondensatoren (C1, C2, C3, C4, C5, C6) und Widerstand gebildeten Filter und zwei elektronische Unterbrecher (11, 12) umfaßt, die Teil des Filters sind und die Veränderung der Breite des Durchlaßbandes des Filters gestatten.

6. Autonomer und personenspezifischer Telefonhörer oder Kopfhörer, dadurch gekennzeichnet, daß er einen Hörteil (1) nach einem der Ansprüche 1 bis 5, eine eingebaute Spannungsquelle, Mittel zur Verbindung mit einem Telefonapparat über einen Saugaufnehmer (2) oder durch Funkverbindung und vom Benützer betätigbare Rädchen (23, 24) umfaßt, die eine Veränderung der Bandmittenfrequenz und der Bandbreite des oder der Filter(s) unabhängig voneinander gestatten.

## Claims

1. Receiver (1) for telephone handset or headphones of the type comprising an electronic adjustable filter permitting the adaptation of the headset response curve to the hearing deficiencies of the user, characterized in that said filter is a pass-band filter (7, 8) and said receiver further comprises, electronic means controlled by means (23, 24) actuatable by the user, and provided for varying independently from one another the central frequency and the passband width of said filter in order to make it correspond to the range of acoustic deficiency of the user.

2. Receiver according to claim 1, characterized in that said electronic means provided for varying independently from each other the central frequency and the band width of said filter comprise electronic switches (9, 10, 11, 12) which are associated to resistors incorporated to said filter and they further comprise means for sending, on the gate of said electronic switches, rectangular pulse trains (19, 20) and, means for varying the cyclic ratio of said pulse trains, this permitting the variation of said resistors and the adjustment, independently from each other, of the central frequency and of the width of the passband of said filter.

3. Receiver according to claim 2, characterized in that said means for sending on the gate of said switches, rectangular pulse trains (19, 20) which have a variable cyclic ratio, comprise a generator (15) of delta voltage of constant frequency, two comparators (16, 17) comparing the increasing voltage supplied by said generator (15) to a reference voltage and two potentiometers (13, 14), actuatable by the user, which make it possible to vary said reference voltage, the resulting effect being to vary the cyclic ratio of the rectangular pulse trains delivered by the two comparators and to vary independently from each other the central frequency and the width of the passband of said filter.

4. Receiver according to claim 2, characterized in that said filter comprises two selective amplifiers (7, 8) and two electronic switches (9, 10) which are mounted in negative feedback loops of said amplifiers and which make it possible to vary the central frequency of said filter.

5. Receiver according to claim 4, characterized in that said filter further comprises a filter composed of capacitors (C1, C2, C3, C4, C5, C6) and of a resistor, and of two electronic switches (11, 12) forming part of said filter and permitting the variation of the width of the passband of said filter.

6. Telephone handset or independent and personalized headphones, characterized in that it comprises a receiver (1) according to any one of claims 1 to 5, an incorporated source of voltage, means of connection with a telephone apparatus by way of a suction sensor (2) or a radio link and wheels (23, 24) actuatable by the user, which makes it possible to vary independently of each other, the central frequency and the band width of the filter or filters.

Fig. 1

Fig. 2

EP 0 176 459 B1

FIG. 3